# FASCICULE DE BREVET EUROPEEN

(11) **EP 0 508 877 B1**
(45) Date de publication et mention de la délivrance du brevet: **05.06.1996**
(21) Numéro de dépôt: 92400959.0
(22) Date de dépôt: 07.04.1992
(51) Int. Cl.: H01Q 3/26, H01Q 21/06

(54) **Procédé de réduction des lobes secondaires du diagramme émission d'une antenne réseau active, et antenne mettant en oeuvre le procédé**
Verfahren zur Reduzierung von Nebenkeulen im Sendediagramm einer aktiven Gruppenantenne und Antenne zur Durchführung des Verfahrens
Method for reduction of side lobes in a radiation pattern of an active antenna array and antenna using the method

(30) Priorité: 12.04.1991 FR 9104512
(43) Date de publication de la demande: 14.10.1992
(73) Titulaire: THOMSON-CSF, 75008 Paris (FR)
(72) Inventeur: Janex, Albert, F-92045 Paris la Défense (FR)
(74) Mandataire: Benoit, Monique

(56) Documents cités:
- EP-A- 0 110 368
- WO-A-88/07786
- US-A- 4 547 746
- ALTA FREQUENZA. vol. 58, no. 2, Mars 1989, MILANO IT pages 89 - 101; R.P.SHENOY: 'Active Aperture Phased Arrays'
- ELECTRONICS & COMMUNICATION ENGINEERING JOURNAL vol. 2, no. 2, Avril 1990, LONDON,GB pages 45 - 51; P.BRADSELL: 'Phased arrays in radar'

## Description

La présente invention concerne un procédé permettant de réduire les lobes secondaires du diagramme émission d'une antenne réseau comportant une pluralité de modules actifs, ainsi qu'une antenne mettant en oeuvre le procédé.

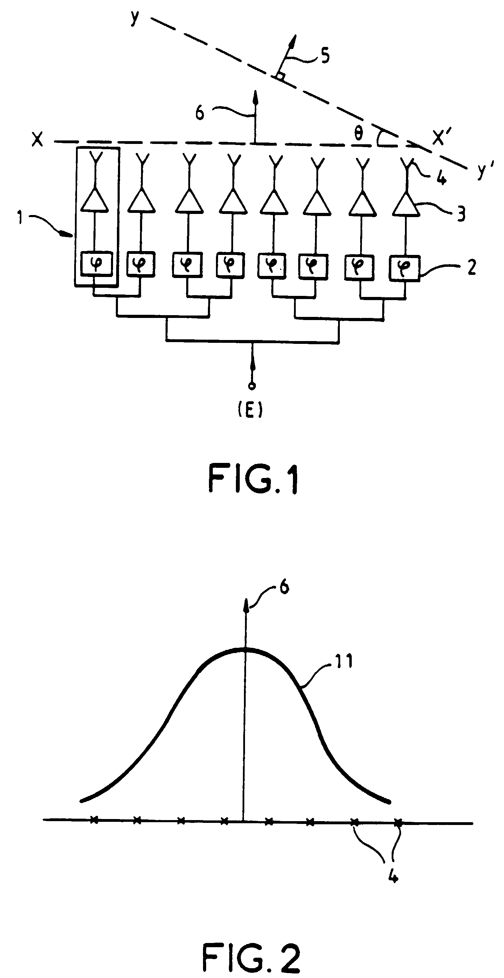

La figure 1 illustre le fonctionnement bien connu d'un réseau linéaire à huit modules actifs lors de l'émission, fonctionnement que l'on peut aisément généraliser à un réseau bidimensionnel : chaque module actif 1 est constitué par la mise en série d'un circuit déphaseur 2, d'un amplificateur de puissance 3, et d'un élément rayonnant 4. Tous les modules actifs 1 reçoivent à l'entrée de leur circuit déphaseur 2, le même signal (E) de même amplitude et phase. En effectuant une modulation linéaire de la phase au moyen des circuits déphaseurs 2, il est possible d'incliner le plan d'onde émis, représenté par l'axe (YY′), d'un angle θ par rapport au plan du réseau (XX′). La direction 5 du faisceau émis est alors inclinée de l'angle θ par rapport à l'axe 6 du réseau que l'on définit comme étant la direction perpendiculaire à l'axe XX′, prise au centre géométrique du réseau.

En sortie des modules actifs 1, c'est-à-dire en sortie des éléments rayonnants 4, les signaux sont tous émis à la même puissance. La rayonnante immédiate est un niveau élevé des lobes secondaires du diagramme d'émission résultant.

Un procédé connu pour abaisser le niveau de ces lobes secondaires consiste à effectuer une modulation de la puissance émise par les modules actifs 1 de façon à ce que cette puissance soit de plus en plus faible pour des éléments rayonnants 4 situés de plus en plus loin de l'axe 6 du réseau, ou du centre géométrique de l'antenne pour généraliser à un réseau bidimensionnel.

La figure 2 est un exemple de loi de répartition de la puissance émise par les éléments rayonnants 4 du réseau de la figure 1. Cette loi de répartition 11 est symétrique par rapport à l'axe 6 du réseau et possède ses valeurs maxima de puissance pour les éléments rayonnants 4 situés près de cet axe.

Une première mise en oeuvre connue du procédé précédent consiste en l'introduction d'atténuateurs programmables en série avec chaque circuit déphaseur 2. Cependant, cette mise en oeuvre n'est pas satisfaisante. En effet, les amplificateurs 4 des modules actifs, qui sont en général des transistors, sont utilisés en classe C, c'est-à-dire au voisinage de la saturation, ceci afin d'avoir un maximum de rendement. Aussi, la puissance de sortie d'un amplificateur 4 ne reflète que très imparfaitement les variations de la puissance d'entrée introduites par l'atténuateur programmable.

Une deuxième mise en oeuvre connue pour faire l'approximation de la loi de répartition de puissance recherchée consiste à faire une pondération de la densité des éléments rayonnants, c'est-à-dire à utiliser un réseau lacunaire. Dans ce type de réseau, les éléments rayonnants restent équipuissants, mais le pas du réseau, c'est-à-dire la distance séparant deux modules actifs successifs, est irrégulier. Cependant, l'approximation de la loi de répartition de puissance recherchée n'est bonne que pour un réseau comprenant un nombre de modules actifs élevé, typiquement de l'ordre du millier.

La présente invention a pour objet un procédé de réduction des lobes secondaires du diagramme d'émission d'une antenne réseau tel que défini dans les revendications 1 à 4.

Ce procédé repose sur deux constatations importantes effectuées par la Demanderesse :
- quelle que soit la loi de répartition de la puissance émise que l'on se donne, celle-ci est indépendante de la loi de phase appliquée au niveau des circuits déphaseurs,
- la puissance émise par un module actif équipé d'un transistor bipolaire travaillant en classe C est sensiblement proportionnelle au carré de la tension d'alimentation de ce transistor.

Un autre objet de l'invention est une antenne mettant en oeuvre, avec des moyens simples, le procédé précédent, telle que définie dans les revendications 5 à 8.

L'invention, ainsi que ses avantages, seront mieux compris au vu de la description suivante d'un mode de réalisation pris à titre d'exemple non limitatif et se référant aux figures annexées :
- La figure 1 schématise le fonctionnement à l'émission d'une antenne réseau linéaire ;
- La figure 2 est un exemple de loi de répartition de la puissance émise permettant la réduction des lobes secondaires du diagramme émission ;
- La figure 3 explique le procédé de réduction des lobes secondaires selon l'invention, appliqué à l'antenne réseau linéaire de la figure 1 pour une loi de répartition donnée par la figure 4 ;
- la figure 5 schématise le procédé selon l'invention appliqué à une antenne réseau bidimensionnelle.

Les figures 1 et 2 ont déjà été décrites précédemment.

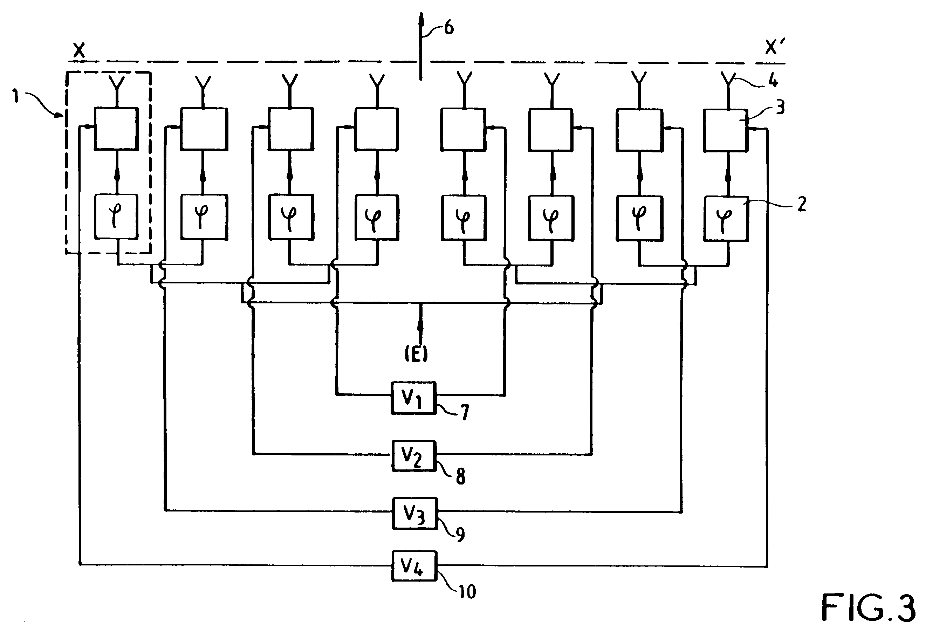

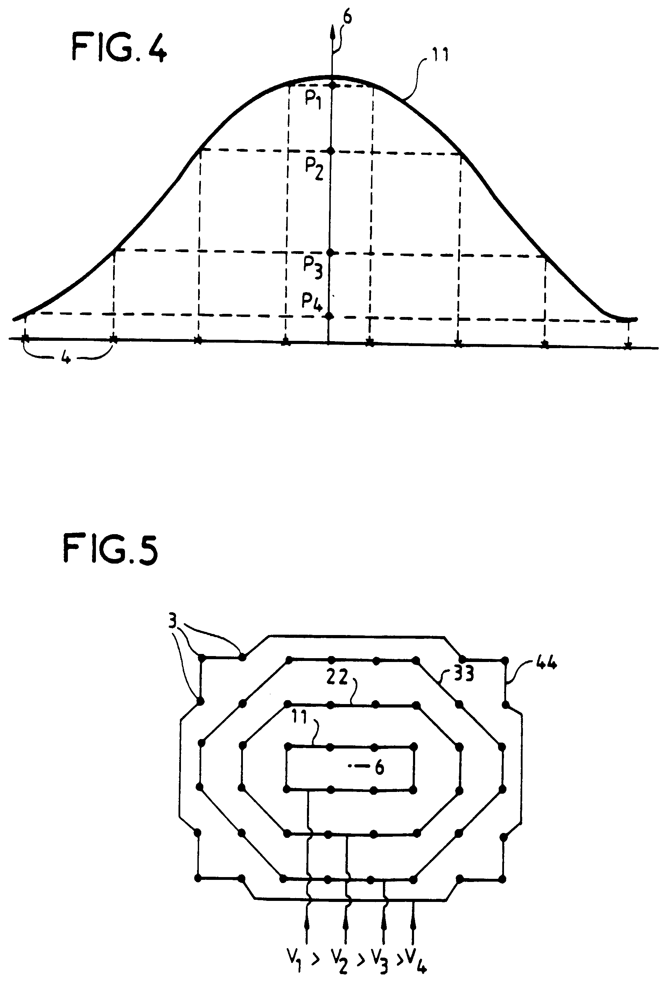

Sur les figures 3 et 4, est expliqué le procédé de réduction des lobes secondaires selon l'invention, appliqué au réseau linéaire de la figure 1. Pour plus de clarté, l'échelle n'a pas été respectée par rapport à la figure 1.

On retrouve sur la figure 3, à titre d'exemple simplifié les huit modules actifs 1 composés chacun d'un circuit déphaseur 2, d'un élément actif 3 faisant office d'amplificateur de puissance, et d'un élément rayonnant 4. Tous les modules actifs 1 reçoivent le même signal (E) de même amplitude et phase. Le procédé selon l'invention propose d'appliquer à chaque élément actif 3 une tension d'alimentation continue fournie par une source 7, 8, 9 ou 10, déterminée à partir de la loi de répartition en puissance émise que l'on désire obtenir. La figure 4 montre une loi de ce type, permettant de réduire le niveau des lobes secondaires. La courbe 11 de la figure 4 permet de déterminer, pour chaque élément rayonnant 4, de la moitié gauche ou droite réseau, la puissance P₁, P₂, P₃ ou P₄ qu'il doit émettre. La courbe étant symétrique par rapport à l'axe 6 de l'antenne, les éléments rayonnants 4 situés de part et d'autre et à égale distance de cet axe reçoivent donc la même valeur de puissance. Les études de la Demanderesse ont montré que les valeurs V₁, V₂, V₃ et V₄ des tensions d'alimentation à appliquer sont sensiblement proportionnelles aux racines carrées des puissances P₁, P₂, P₃, P₄.

La figure 5 illustre le procédé de réduction des lobes secondaires selon l'invention, appliqué à une antenne réseau bidimensionnelle comprenant 48 modules actifs. Sur cette figure, on a représenté schématiquement par des points les éléments actifs 3. Des lignes équipotentielles 11, 22, 33 et 44, correspondant respectivement aux tensions d'alimentation continues V₁, V₂, V₃ et V₄, relient les éléments actifs 3. Dans une telle antenne bidimensionnelle, la puissance à rayonner par chaque élément actif 3 doit d'abord être déterminée selon des procédés classiques connus. De façon habituelle, on prend le ou les éléments 3 situés au centre de l'antenne, et l'on calcule ce qu'il faut appliquer aux éléments 3 situés sur l'axe horizontal de l'antenne d'une part, et sur l'axe vertical d'autre part. Pour un élément 3 qui n'est pas situé sur l'un de ces deux axes, on considère qu'il faut lui appliquer le produit de ce qui est appliqué à son abscisse par ce qui est appliqué à son ordonnée. Les lignes équipotentielles 11, 22, 33, et 44 sont alors tracées pour relier entre eux les éléments 3 pour lesquels la puissance est proche de P₁, P₂, P₃ et P₄. Les lignes ont pour axe de symétrie les axes de symétrie de l'antenne.

La mise en oeuvre du procédé selon l'invention dépend du type d'éléments actifs utilisés. Pour des fréquences allant jusqu'à environ 3 GHz, on utilise généralement un transistor bipolaire en classe C. Dans ce cas, la tension d'alimentation est appliquée entre le collecteur et l'émetteur du transistor. Au-delà de 3 GHz, les transistors bipolaires ne sont plus utilisables, et l'on a généralement recours à des transistors à effet de champ, par exemple, à arséniure de gallium. Pour ce type de transistors, la puissance de sortie peut être commandée par la tension de polarisation appliquée à la grille du transistor, qu'il soit monogrille ou bigrille ; ainsi, le procédé selon l'invention est applicable en considérant que la tension d'alimentation est la tension de la grille ou d'une des deux grilles suivant qu'il s'agit d'un transistor monogrille ou bigrille. Cependant, avec ce type de transistors, la tension appliquée à la grille n'est pas proportionnelle à la puissance désirée.

Le procédé selon l'invention a été décrit d'un point de vue théorique en ce sens qu'il utilise des lois de répartition de puissance prédéterminées pour en déduire exactement la valeur de la tension d'alimentation qu'il faut appliquer pour chaque module actif. Dans la pratique, il n'est pas indispensable de respecter finement ces lois de répartition et l'on pourra se contenter de les approximer. Dans le cas d'une antenne monodimensionnelle, on pourra utiliser une même tension pour alimenter plusieurs éléments 3. De même, pour une antenne bidimensionnelle, une même tension pourra alimenter une zone large de plusieurs pas entre les éléments actifs 3. Ceci simplifie la complexité de l'antenne, en particulier pour des antennes possédant un grand nombre d'éléments. La courbe d'allure Gaussienne de la figure 2 est alors approximée par une suite de créneaux plus ou moins grossière. En contrepartie, plus l'approximation est grossière, plus le diagramme d'émission de l'antenne présente des lobes secondaires élevés.

Dans certains cas, il peut être intéressant de choisir une loi de répartition qui n'est pas symétrique par rapport au centre géométrique de l'antenne, mais par rapport à un élément actif que l'on choisit pour rayonner la puissance maximale.

Il est important de souligner également que, outre le fait que le procédé selon l'invention permet de réduire le niveau des lobes latéraux, il permet en même temps de réduire la puissance dissipée dans l'antenne. Ainsi, le procédé selon l'invention permet de faire des économies d'énergie tout en simplifiant les problèmes de dissipation thermique de l'antenne et de réduire la possibilité de détection de l'antenne par un senseur infra-rouge.

En outre, la présente invention ne se limite pas à des antennes réseau linéaires ou bidimensionnelles, et peut tout à fait s'étendre à des antennes réseau volumiques.

Enfin, la construction d'une antenne réseau mettant en oeuvre le procédé nécessite des moyens simples pour les sources V₁ à V₄ puisqu'il s'agit de tous moyens fonctionnant comme une source d'alimentation en tension constante, à tension programmable.

## Revendications

1. Procédé de réduction des lobes secondaires du diagramme d'émission d'une antenne réseau comportant une pluralité de modules actifs constitués chacun d'un élément actif d'amplification de puissance, ledit procédé étant caractérisé en ce qu'il consiste à :
- choisir au moins un premier élément actif auquel on applique une première tension d'alimentation constante ;
- appliquer à chacun des éléments actifs successifs en s'éloignant dudit premier élément actif, une tension d'alimentation constante, inférieure ou égale à la tension appliquée à l'élément actif précédent, les valeurs desdites tensions d'alimentation étant calculées de façon univoque à partir des puissances émises par les éléments actifs selon une loi de répartition de puissance prédéterminée.

2. Procédé selon la revendication 1, caractérisé en ce que la loi de répartition est d'allure sensiblement gaussienne et centrée sur ledit premier élément actif.

3. Procédé selon la revendication 2, caractérisé en ce que chaque élément actif est un transistor bipolaire, et en ce que la valeur de la tension d'alimentation pour cet élément actif est sensiblement proportionnelle à la racine carrée de la puissance émise.

4. Procédé selon l'une quelconque des revendications précédentes, caractérisé en ce que ledit premier élément actif est le plus proche du centre géométrique de l'antenne.

5. Antenne réseau pour la mise en oeuvre du procédé selon les revendications 1 à 4, comportant une pluralité de modules actifs, lesquels sont constitués chacun d'un élément actif utilisé comme amplificateur de puissance délivrant une puissance émise selon une loi de répartition de puissance prédéfinie, l'antenne réseau étant caractérisée en ce qu'elle comporte plusieurs sources d'alimentation en tension reliées chacune à au moins un élément actif, l'une de sources d'alimentation délivrant à au moins un premier élément actif une première tension d'alimentation constante, les autres sources d'alimentation appliquant aux éléments actifs successifs en s'éloignant dudit premier élément actif, une tension d'alimentation constante, inférieure ou égale à la tension appliquée à l'élément actif précédent, les valeurs desdites tensions d'alimentation étant calculées de façon univoque à partir des puissances émises par les éléments actifs selon ladite loi de répartition de puissance prédéfinie.

6. Antenne réseau selon la revendication 5, caractérisée en ce que ledit élément actif est un transistor bipolaire et en ce que la source d'alimentation qui lui est reliée applique ladite tension constante entre le collecteur et l'émetteur.

7. Antenne réseau selon la revendication 5, caractérisée en ce que ledit élément actif est un transistor à effet de champ monogrille, et en ce que la source d'alimentation qui lui est reliée applique ladite tension constante à la grille de ce transistor.

8. Antenne réseau selon la revendication 5, caractérisée en ce que ledit élément actif est un transistor à effet de champ bigrille, et en ce que la source d'alimentation qui lui est reliée applique ladite tension constante à l'une quelconque des deux grilles de ce transistor.

## Patentansprüche

1. Verfahren zur Verringerung der Sekundärkeulen des Sendediagramms einer Netzantenne mit zahlreichen aktiven Moduln, die je von einem aktiven Leistungsverstärkungselement gebildet werden, dadurch gekennzeichnet, daß
- mindestens ein erstes aktives Element gewählt wird, an das eine erste konstante Speisespannung angelegt wird,
- an jedes der weiteren aktiven Elemente ausgehend von dem ersten aktiven Element eine konstante Speisespannung angelegt wird, die kleiner oder gleich der an das vorhergehende aktive Element angelegten Spannung ist, wobei die Werte der Speisespannungen eindeutig ausgehend von den durch die aktiven Elemente ausgesendeten Leistungen gemäß einem vorgegebenen Leistungsverteilungsgesetz berechnet werden.

2. Verfahren nach Anspruch 1, dadurch gekennzeichnet, daß das Verteilungsgesetz eine im wesentlichen Gauss'sche Kurve bildet, die auf das erste aktive Element zentriert ist.

3. Verfahren nach Anspruch 2, dadurch gekennzeichnet, daß jedes aktive Element ein bipolarer Transistor ist und daß der Wert der Speisespannung für dieses aktive Element im wesentlichen proportional zur Quadratwurzel der ausgesendeten Leistung ist.

4. Verfahren nach einem beliebigen der vorhergehenden Ansprüche, dadurch gekennzeichnet, daß das erste aktive Element dasjenige ist, das dem geometrischen Zentrum der Antenne am nächsten liegt.

5. Netzantenne für die Durchführung des Verfahrens nach den Ansprüchen 1 bis 4, mit zahlreichen aktiven Moduln, die je von einem als Leistungsverstärker verwendeten aktiven Element gebildet werden und eine Leistung gemäß einem vordefinierten Leistungsverteilungsgesetz aussenden, dadurch gekennzeichnet, daß die Antenne mehrere Speisespannungsquellen besitzt, die je an mindestens ein aktives Element angeschlossen sind, wobei eine der Speisespannungsquellen an mindestens ein erstes aktives Element eine erste konstante Speisespannung liefert, während die anderen Speisespannungsquellen an die folgenden aktiven Elemente, je weiter man sich von dem ersten aktiven Element entfernt, eine konstante Speisespannung liefern, die kleiner als die oder gleich der an das vorhergehende aktive Element angelegten Spannung ist, wobei die Werte der Speisespannungen eindeutig aufgrund der von den aktiven Elementen ausgesendeten Leistungen gemäß dem vordefinierten Leistungsverteilungsgesetz berechnet werden.

6. Netzantenne nach Anspruch 5, dadurch gekennzeichnet, daß das aktive Element ein bipolarer Transistor ist und daß die an dieses Element angeschlossene Speisespannungsquelle die konstante Spannung zwischen den Kollektor und den Emitter anlegt.

7. Netzantenne nach Anspruch 5, dadurch gekennzeichnet, daß das aktive Element ein Feldeffekttransistor mit einem Gate ist und daß die an dieses Element angelegte Speisespannungsquelle die konstante Spannung an das Gate dieses Transistors anlegt.

8. Netzantenne nach Anspruch 5, dadurch gekennzeichnet, daß das aktive Element ein Feldeffekttransistor mit zwei Gates ist und daß die mit ihm verbundene Speisespannungsquelle die konstante Spannung an ein beliebiges der beiden Gates dieses Transistors anlegt.

## Claims

1. Method of reducing the side lobes of the radiation diagram of an array antenna including a plurality of active modules each consisting of an active element for power amplification, the said method being characterized in that it consists in:
- choosing at least one first active element to which a first constant power supply voltage is applied;
- applying to each of the successive active elements, moving away from the said first active element, a constant power supply voltage, less than or equal to the voltage applied to the preceding active element, the values of the said power supply voltages being calculated in a one-to-one way on the basis of the powers emitted by the active elements according to a predetermined power distribution law.

2. Method according to Claim 1, characterized in that the distribution law is of substantially gaussian profile and is centred on the said first active element.

3. Method according to Claim 2, characterized in that each active element is a bipolar transistor, and in that the value of the power supply voltage for this active element is substantially proportional to the square root of the power emitted.

4. Method according to any one of the preceding claims, characterized in that the said first active element is closest to the geometrical centre of the antenna.

5. Array antenna for implementing the method according to Claims 1 to 4, including a plurality of active modules, which each consist of an active element used as power amplifier delivering a power emitted according to a predefined power distribution law, the array antenna being characterized in that it includes several voltage supply sources each linked to at least one active element, one of the power supply sources delivering a first constant power supply voltage to at least a first active element, the other power supply sources applying, to the successive active elements moving away from the said first active element, a constant power supply voltage, less than or equal to the voltage applied to the preceding active element, the values of the said power supply voltages being calculated in a one-to-one way on the basis of the powers emitted by the active elements according to the said predefined power distribution law.

6. Array antenna according to Claim 5, characterized in that the said active element is a bipolar transistor and in that the power supply source which is linked to it applies the said constant voltage between the collector and the emitter.

7. Array antenna according to Claim 5, characterized in that the said active element is a single-gate, field-effect transistor, and in that the power supply source which is linked to it applies the said constant voltage to the gate of this transistor.

8. Array antenna according to Claim 5, characterized in that the said active element is a dual-gate field-effect transistor, and in that the power supply source which is linked to it applies the said constant voltage to either of the two gates of this transistor.
